# EUROPÄISCHE PATENTSCHRIFT

(11) **EP 1 157 410 B1**
(45) Veröffentlichungstag und Bekanntmachung des Hinweises auf die Patenterteilung: **11.04.2007**
(21) Anmeldenummer: 00912378.7
(22) Anmeldetag: 16.02.2000
(51) Int. Cl.: H01L 21/02

(54) **EIN VERFAHREN ZUR HERSTELLUNG EINES MINIATURISIERTEN KONDENSATORS**
A METHOD OF PRODUCING A MINIATURISED CAPACITOR
UN PROCEDE DE FABRICATION D'UN CONDENSATEUR MINIATURISE

(30) Priorität: 23.02.1999 DE 19907760
(43) Veröffentlichungstag der Anmeldung: 28.11.2001
(73) Patentinhaber: Infineon Technologies AG, 81669 München (DE)
(72) Erfinder: WILLER, Josef, D-85521 Riemerling (DE); SCHLÖSSER, Till, D-81825 München (DE); BERTAGNOLLI, Emmerich, A-1190 Wien (AT)
(74) Vertreter: Kottmann, Heinz Dieter
(86) Internationale Anmeldenummer: PCT/DE2000/000436
(87) Internationale Veröffentlichungsnummer: WO 2000/051171

(56) Entgegenhaltungen:
- EP-A- 0 553 791
- US-A- 5 760 434
- US-A- 5 877 063
- DOSCHER M ET AL: "A STUDY ON WSI2 THIN FILMS, FORMED BY THE REACTION OF TUNGSTEN WITHSOLID OR LIQUID SILICON, BY RAPID THERMAL ANNEALING" THIN SOLID FILMS,CH,ELSEVIER-SEQUOIA S.A. LAUSANNE, Bd. 239, Nr. 2, 1. März 1994 (1994-03-01), Seiten 251-258, XP000429721 ISSN: 0040-6090

## Beschreibung

Die vorliegende Erfindung bezieht sich auf ein Verfahren zur Herstellung eines miniaturisierten Kondensators mit Festkörperdielektrium (MIM- bzw. MIS-Kondensator), wie er insbesondere für integrierte Halbleiterschaltungen und vorzugsweise für Speicher (Memories), z.B. DRAMs, vorteilhaft zu verwenden ist. Bekannt sind solche Kondensatoren aus z.B. US-A-5760434, GB-A-2294591, EP-A-0553791 IEDM 1998 San Francisco: Y.S. Chun et al. Und 1997 Symp. On VLSI Tech. Digest of Tech. Papers: J.M. Drynan et. al., S. 151, 152.

Schon Jahrzehnte bekannt sind Tantaloxid(Ta₂O₅-)Kondensatoren. Deren hohe spezifische Kapazität beruht im wesentlichen auf der relativ hohen Dielektrizitätskonstanten und der geringen Dicke der Tantaloxid-Dielektrikumsschicht. Weiter ist für hohe spezifische Kapazität eine möglichst große Oberfläche wichtig, wobei, insbesondere von Elektrolytkondensatoren her bekannt, eine möglichst stark aufgerauhte flächenvergrößerte Oberfläche der Elektrode wesentlich ist.

Für DRAMs (Dynamic Random Access Memories) werden bereits seit längerem MIM-/MIS-Kondensatoren verwendet. Bekannt sind aus Drynan et al, 1997, Symposium on VLSI Technology Digest of Technical Papers, S. 151 bis 152, Kondensatoren, die eine erste Elektrode aus Wolfram, ein Tantalpentoxid-Dielektrikum und eine zweite Elektrode aus z.B. Titannitrid (TiN) haben. Es ist auch bekannt (EP-0553791), bei einem Kondensator mit Silizium-Halbleiterelektrode eine aufgerauhte Oberfläche dieser Elektrode durch anodisches Ätzen, selektives Ätzen, Ätzen mit zusätzlicher UV-Lichteinwirkung, Trockenätzen von Silizium oder einer amorphen Siliziumschicht oder durch eine Rekristallisation einer zuvor aufgebrachten amorphen Siliziumschicht (bekannt als HSG-Verfahren = Hemispherical Graining) zu erzielen.

Aus der US-A-5760434 sind ein DRAM-Kondensator und sein Herstellungsverfahren bekannt. Die eine, als Bottom-Elektrode bezeichnete Kondensatorelektrode, die mit dem Transistor der Speicherzelle verbunden ist, besteht dort aus TiN. Es ist dort dies eine dünne Schicht in Form eines Bechers auf die umgebende Seitenwand bildendem Siliziumoxid. Die Innenwand dieser becherförmig ausgebildeten TiN-Schicht ist mit Silizium beschichtet. Dieses Silizium ist mit Hilfe des HSG-Verfahrens in hemispherical grained Silizium umgewandelt, so dass dieses Silizium auf der dabei unverändert gebliebenen TiN-Unterlage die bekanntermaßen gekörnte Struktur/Struktur-Oberfläche mit mehrfach vergrößerter Oberfläche hat. Diese vergrößerte Oberfläche des leitenden HSG-Polysiliziums bildet die eine Elektrodenfläche, die mit einem Dielektrikum beschichtet ist. Dieses Dielektrikum ist mit der zweiten Elektrode (Top Electrode) zur Komplettierung des Kondensators beschichtet.

Aufgabe der vorliegenden Erfindung ist es, ein vorteilhaftes und zuverlässig reproduzierbares Verfahren zur Herstellung eines miniaturisierten Kondensators anzugeben, bei dem die beiden an das Dielektrikum angrenzenden Elektroden, insbesondere die Oberfläche der Bottom-Elektrode aus elektronisch leitendem Metall mit entsprechend hoher elektrischer Leitfähigkeit bestehen und dennoch die Elektrodenfläche eine hohe Oberflächenvergrößerung aufweist, wie sie mit dem HSG-Verfahren für halbleitendes Material erreichbar ist.

Diese Aufgabe wird erfindungsgemäß durch ein Verfahren mit den Merkmalen des Patentanspruches 1 gelöst. Weitere Ausgestaltungen der Erfindung gehen aus den Unteransprüchen hervor.

Für einen DRAM-Kondensator ist es bekannt, für dessen erste (Bottom-)Elektrode eine Form mit makroskopisch großer Oberfläche vorzusehen. Zum Beispiel ist dies neben einer Glockenform, der Form einer Bohrung z.B. auch die einer Säule. Solche makroskopischen Formen sind für die einschlägigen Kondensatoren für das Erreichen einer hohen Kapazität hinlänglich bekannt.

Es ist vorgesehen, dass das Material der ersten Elektrode wenigstens im Bereich unterhalb ihrer Elektrodenoberfläche elektrisch möglichst gut leitfähig ist. Deshalb besteht entweder die ganze Elektrode oder wenigstens der oberflächennahe Bereich derselben aus dem elektronisch, d.h. metallisch gut leitfähigen Wolframsilizid. Für den zweiten vorangehend genannten Fall kann als Kern eines solchen oberflächennahen Wolframsilizid-Bereichs alternativ auch Polysilizium vorgesehen sein.

Das Wolframsilizid der ersten Elektrode bzw. wenigstens deren oberflächennaher Bereich enthält einen stöchiometrischen Überschuss an Silizium. Der Siliziumanteil kann zu x = 2,0 bis 2,5 im WSiₓ bemessen sein.

Auf die Oberfläche dieses bevorzugt überstöchiometrischen Wolframsilizids wird eine erste Schicht aus nun unterstöchiometrischem Wolframsilizid, z.B. WSi_{1,8}, mit einen Siliziumanteil zwischen z.B. 1,5 bis 1,9 aufgebracht. Die Dicke einer solchen Schicht wird auf etwa 10 bis 30 nm bemessen. Aufzubringen ist eine solche Schicht z.B. nach bekannten CVD-Abscheideverfahren aus z.B. Wolframfluorid (WF₆) und z.B. Silan.

Auf diese erste Schicht wird eine weitere Schicht aus reinem bzw. keinen Zusatz enthaltendem Silizium aufgebracht, wieder z.B. mit Hilfe einer CVD-Abscheidung. Diese Schicht wird z.B. auf 10 bis 30 nm bemessen.

Diese erste (Bottom-)Elektrode mit diesen zwei Beschichtungen wird nunmehr bei z.B. 800 bis 1100°C für eine Zeitdauer von z.B. 1 bis 10 sec in einer inerten Atmosphäre getempert. Bei diesem Prozessschritt geht das Material der unterstöchiometrischen ersten Schicht in zumindest weitgehend stöchiometrisches Wolframsilizid WSi₂ über. Es wird ausgenutzt, dass mit den angegebenen Prozessgrößen mit diesem Übergang in das stöchiometrische Wolframsilizid ein Wachsen einer Körnung (grained) einhergeht. Es ist dies ein Kornwachstum in bzw. wenigstens auf der Oberfläche der ersten Schicht. Diese entstehende Körnung der ersten Schicht ergibt eine wesentliche Oberflächenvergrößerung der für den Kondensator relevanten Elektrodenfläche der ersten Elektrode.

Im folgenden Verfahrensschritt erfolgt das Wegätzen des noch vorhandenen Siliziums der zweiten Schicht, herunter bis auf die nunmehr die Körnung aufweisende erste Schicht. Damit ist die Wolframsilizid-Oberfläche völlig freigelegt. Es empfiehlt sich nun eine Passivierung der körnigen Oberfläche der ersten Elektrode vorzunehmen. Geeignet ist dafür eine thermische Nitrid-Beschichtung in im wesentlichen einer Monolage, z.B. mit einer Dicke unterhalb 1 nm. Die Nitridbildung kann insbesondere durch Einwirkung von NH₃ erfolgen. Der Sinn dieser Passivierung ist, die Bildung jeglichen Siliziumdioxids auf der Elektrodenoberfläche zu vermeiden.

Dies würde nämlich die Kapazität des Kondensators stark herabsetzen.

Nunmehr wird auf die durch die erzielte Körnung mehrfach oberflächenvergrößerte Elektrodenfläche der ersten Elektrode das eigentliche, z.B. SiN-Dielektrikum des Kondensators aufgebracht. Geeignet ist hierfür eine CVD-Abscheidung von SiN aus z.B. NH₃ und Silan. Zusätzlich kann vorteilhafterweise, nämlich um die Defektdichte zu reduzieren, das Nitrid,
- vorzugsweise jedoch nur teilweise -, aufoxidiert werden, so dass eine dünne Oxidschicht, sogenanntes Top-Oxid, entsteht.

Diese Oxidation mit einer Tiefe von z.B. bis zu 1 nm tief in die SiN-Dielektrikumsschicht hinein führt zu einer Absättigung offener Bindungen.

Es kann alternativ als Dielektrikum auf die Nitridpassivierung auch Tantalpentoxid als Schicht mittels CVD-Abscheidung oder aus einer dafür bekanntermaßen zu verwendenden organischen Tantalverbindung oder dgl. abgeschieden werden. Es empfiehlt sich, die Oberfläche des wie voranstehend aufgebrachten Tantaloxid-Dielektrikums noch einem Tempern in einer sauerstoffhaltigen Atmosphäre zu unterwerfen. Diese Maßnahme ist dahingehend effektiv, die Defektdichte innerhalb der Dielektrikumsschicht, insbesondere in den Korngrenzen des Dielektrikums, zu verringern. Es lässt sich damit eine wesentliche Verringerung des für einen Kondensator nachteiligen Leckstromes erreichen.

Mit diesen beiden voranstehend beschriebenen Maßnahmen zur Verringerung der Defektdichte lässt sich auch die Pinhole-Dichte reduzieren.

Die Dicke der jeweiligen Dielektrikums-Schicht richtet sich nach der für den Kondensator geforderten Spannungsfestigkeit. Eine dickere Schicht vermindert zwar den erreichbaren Wert der spezifischen Kapazität des Kondensators, erhöht aber dessen Spannungsfestigkeit. Typisch ist eine Oxid-äquivalente Dicke der Schicht zwischen ca. 1 und 5 nm.

Die freie Oberfläche des Dielektrikums wird mit der zweiten Elektrode des Kondensators bedeckt. Diese zweite Elektrode kann bestehen aus z.B. Titannitrid, Polysilizium, Wolfram, Wolframnitrid, Wolframsilizid und dergleichen.

Die nachfolgend beschriebenen Figuren sollen die Erfindung auch in dieser Weise erläutern.

Die Figur 1 zeigt erste Verfahrensschritte der Herstellung der ersten Elektrode eines Kondensators.

Die Figuren 2, 2a, 2b bis 5 zeigen weitere Verfahrensschritte.

Figur 6 zeigt Stand der Technik.

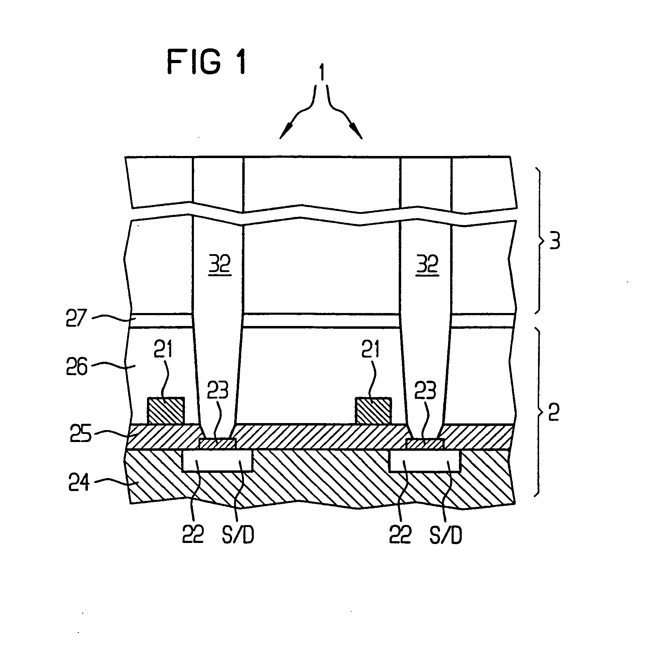

In Figur 1 sind erste Schritte für das Entstehen zweier benachbarter DRAM-Speicherzellen als Schnittansicht dargestellt. Mit 2 ist der bekannte Aufbau der Elektronik eines Speichers (ohne dargestellte Wortleitungen) für zwei solche Speicherzellen gezeigt. Mit 21 sind zwei dargestellte Bitleitungen bezeichnet. Mit 22 bezeichnet sind Source-/ Drain-Gebiete der zwei Speicherzellen. Mit 23 bezeichnet sind sogenannte Landing Pads, die eine elektrische Verbindung zwischen dem jeweiligen Source-Gebiet und dem noch zu beschreibenden Speicherkondensator bilden. Mit 24 sind ein Halbleitersubstrat, mit 25 eine elektrische Isolatorschicht und mit 26 eine als Zwischendielektrikum (BPSG) bekannte Schicht bezeichnet. Diese Schicht 26 ist mit einer als Ätzstop dienenden, z.B. aus einem Nitrid bestehenden Schicht 27 abgedeckt.

Der mit 3 bezeichnete Bereich des Aufbaus in Figur 1 ist für den Kondensator und seine erfindungsgemäße Herstellung vorgesehen. Mit 31 ist eine zunächst ganzflächig auf der Schicht 27 aufgebrachte Oxidschicht aus z.B. Siliziumoxid bezeichnet. Bekannt ist diese Schicht auch unter der Bezeichnung Frame-Schicht. Diese Schicht hat z.B. eine Dicke von 500 bis 1000 nm. Wie aus der Figur 1 ersichtlich wird für einen jeweiligen Kondensator je eine Aussparung, hier je ein Loch 32, in diese Oxidschicht 31 hineingeätzt. Die Form der Aussparung richtet sich nach der gewünschten makroskopischen Form der ersten Elektrode. Für die Positionierung eines jeweiligen dieser Löcher 32 wird eine photolithographische Maskierung auf der oberen Oberfläche der Oxidschicht 31 ausgeführt. Das jeweilige Loch 32 wird bis auf die obere Oberfläche des jeweiligen Landing Pad 23 geätzt, und zwar auch durch die Ätzstop-Schicht 27 hindurch und in die Isolatorschicht 25 hinein. Ein solches Loch 32 hat eine Circa-Abmessung von z.B. 150 nm.

Nach dem Herstellen dieser jeweiligen Löcher 32 in der Frame-Schicht 31 werden diese Löcher 32 mit Wolframsilizid mit insbesondere stöchiometrischem Überschuss an Silizium (WSi₂₋₂₅) gemäß einer ersten Variante aufgefüllt. Daraufhin wird die Oxidschicht 31 durch Ätzen wieder entfernt. Damit wird das Wolframsilizid oberhalb der Ätzstop-Schicht 27 zu einem jeweils freistehenden säulenförmigen Körper 132. Diese hat elektrischen Kontakt mit dem Landing Pad 23 und damit mit dem Source-Gebiet 22 des Speichertransistors.

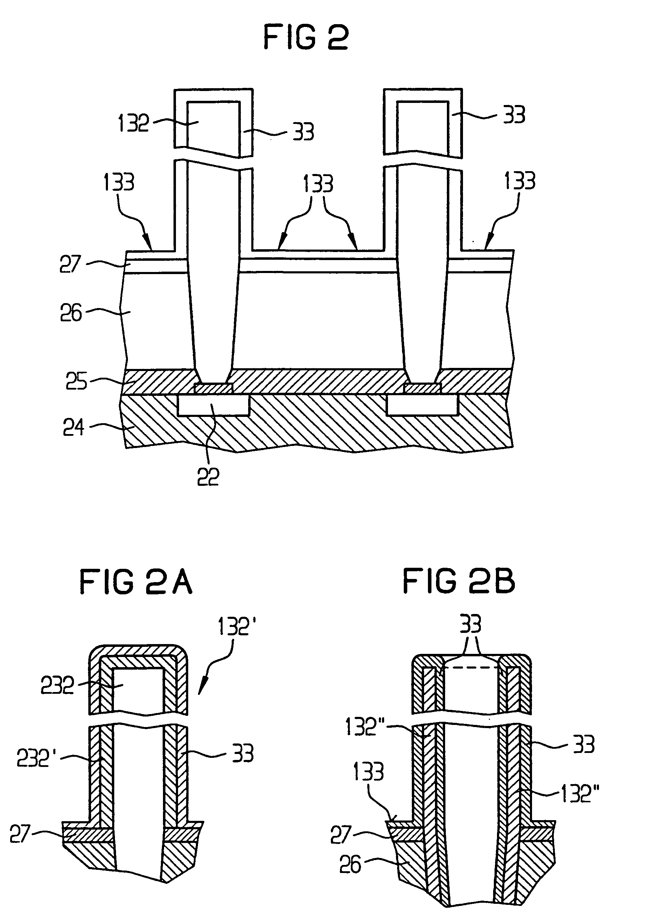

Es ist bereits oben erwähnt, dass die erste (Bottom-)Elektrode insbesondere in ihrem oberflächennahen Bereich aus dem angegebenen Wolframsilizid besteht und der Kern der Elektrode z.B. auch Polysilizium sein kann. Entgegen der Verfahrensweise der vorangehenden Zeilen können als Alternative die jeweiligen Löcher 32 in der Frame-Schicht 31 auch mit für Leitfähigkeit dotiertem Polysilizium gefüllt werden. Die nach dem Wegätzen der Oxidschicht 31 dann aus diesem Polysilizium bestehenden Säulen 232 werden daraufhin mit wie oben angegebenem Wolframsilizid als oberflächennaher Bereich so dick beschichtet, dass dies, vergleichsweise zu einer nur aus dem Wolframsilizid bestehenden Elektrode, eine praktisch ebenso gut leitende Kondensatorelektrode ergibt. Die Figur 2a zeigt als Ausschnitt eine solche Säule 132' mit dem Kern 232 aus dem Polysilizium und mit dem oberflächennahen Bereich 232' aus dem angegebenen Wolframsilizid.

Eine noch weitere Alternative für die makroskopische Form der ersten (Bottom-)Elektrode zeigt die Figur 2b. In der nach Figur 1 hergestellten Aussparung, z.B. dem Loch 32, in der Schicht 31 wird das für die erste Elektrode zumindest im oberflächennahen Bereich der Elektrode vorgesehene Wolframsilizid auf der Wandung dieser Aussparung/dieses Loches 32 als Schicht abgeschieden, und zwar so, dass elektrische Verbindung mit dem Landing Pad 23 (und damit mit dem Source-Gebiet 22) besteht. Diese Schicht wird derart aufgebaut, dass sie stabil als hohlzylindrischer Körper 132" stehenbleibt, nämlich wenn der Rest der Schicht 31 entsprechend dem nachfolgenden Verfahrensschritt vollkommen entfernt worden ist. Die Figur 2b zeigt dieses Stadium mit weiter auf dem Körper 132" bereits abgeschiedener Schicht 33. Je nach Ausführung des fertigen Kondensators erfolgt die Abscheidung der Schicht 33 auf der Innenseite und/oder der Außenseite desselben.

Erfindungswesentlich wird nunmehr auf der Oberfläche der Säulen 132, 132' (bei anderen Formen des Körpers, z.B. 132", auf deren Oberfläche), wie oben in der Beschreibung näher ausgeführt, unterstöchiometrisches Wolframsilizid abgeschieden. Die Figuren 2 bis 2b zeigen die dabei entstandene Schicht 33. Diese Abscheidung erfolgt mit insoweit nicht gleichmäßiger Dicke, so dass die mit 133 bezeichnete Wolframsilizid-Beschichtung der Oberfläche der Schicht 27 nur etwa halb so dick ist, wie das Wolframsilizid auf der Säule 132 abgeschieden ist. Das abgeschiedene Wolframsilizid ist wie in der vorangehenden Beschreibung ausführlich dargelegt unterstöchiometrisch bemessen. Es folgt nunmehr eine teilweise wirkende RIE-Ätzung, mit der die dünnere Beschichtung 133 wenigstens so weit weggeätzt wird, dass die Beschichtungen 33 der einzelnen Säulen 132 elektrisch voneinander getrennt werden. Dabei kann zwar die Beschichtung 33 der Säule 132 dünner werden.

Wegen der zuvor dickeren Bemessung der Schicht bleibt diese Beschichtung jedoch ausreichend dick.

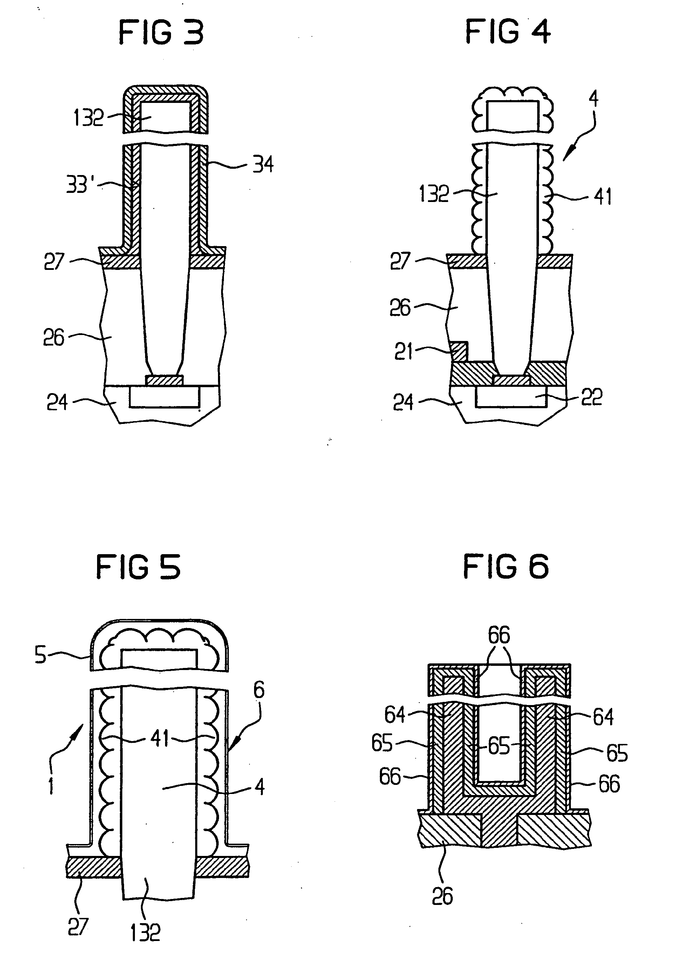

Weiter erfindungswesentlich wird nunmehr auf die nach dem Ätzen verbliebene jeweilige Beschichtung 33' eine zusätzliche Schicht 34 aus reinem (Poly)Silizium aufgebracht. Der nächste wesentliche Verfahrensschritt ist ein Tempern des nunmehr erreichten Aufbaus. Dabei geht das unterstöchiometrische Wolframsilizid der Schicht 33' zusammen mit Silizium der Schicht 34 in ein solches Wolframsilizid über, das dabei erfindungswesentlich die oben erwähnte Körnung 41 (siehe auch Figur 4) der Oberfläche annimmt bzw. erfährt. Damit wird eine mehrfache Vergrößerung der Oberfläche der Elektrode 4 erreicht. Ein nächster Verfahrensschritt ist, restliches, auf der nunmehr gekörnten Wolframsilizid-Oberfläche (und der Oberfläche der Schicht 27) verbliebenes Silizium bis auf die Oberfläche der entstandenen Körnung herunter wieder wegzuätzen. Es kann dies wiederum durch nasschemisches Abätzen erfolgen. Bestehen bleibt nunmehr die erste (Bottom-) Elektrode 4 des jeweiligen Kondensators der jeweiligen Speicherzelle.

Zur Komplettierung des Kondensators empfiehlt es sich, eine dielektrische Passivierung der gekörnten Oberfläche der Wolframsilizid-(Bottom-)Elektrode 4 vorzunehmen. Es kann dies z.B. eine thermische Nitrierung sein mit vorzugsweise in der Dicke einer Monolage mit kleiner 1 nm. Als Dielektrikum des Kondensators ist z.B. Siliziumnitrid vorgesehen. Dieses kann mit Hilfe einer CVD-Abscheidung aus NH₃ und Silan auf der Oberfläche der ersten Elektrode 4 als Schicht 5 aufgebracht werden. Die erste Elektrode mit gekörnter Wolframsilizid-Oberfläche kann auch mit Tantalpentoxid als Dielektrikum beschichtet werden. Maßnahmen zur Verbesserung des Dielektrikums sind bereits in der vorangehenden Beschreibung genannt.

Als zweite (Top-)Elektrode 6 kann z.B. Titannitrid vorgesehen sein. Dieses wird durch konforme Abscheidung auf die Schicht 5 des Dielektrikums aufgebracht. Weitere für die zweite Elektrode geeignete Materialien sind in der obigen Beschreibung genannt. Figur 5 zeigt den fertigen erfindungsgemäß hergestellten Kondensator 1.

Die Erfindung ist voranstehend für ein Herstellungsverfahren eines Kondensators in der Ausführung mit einer ersten (Bottom-)Elektrode 4 mit der makroskopischen Form einer Säule 132 beschrieben worden. Die Erfindung lässt sich jedoch auch für die Herstellung von Kondensatoren mit anderen Formen der ersten Elektrode mit demselben Erfolg anwenden. Dazu ist dann die Aussparung in der Oxidschicht, hier das Loch 32, ggfs. auch entsprechend anders gestaltet zu wählen oder die makroskopische Form des Kerns der ersten Elektrode alternativ auch auf anderweitige Art herzustellen.

Die Figur 6 zeigt aus Drynan, Figur 3, den dort angegebenen Aufbau des in der Beschreibungseinleitung beschriebenen Speicherkondensators. Mit 64 ist die dort topfförmige erste Elektrode bezeichnet. Auf der Oberfläche dieser Elektrode 64 befindet sich die Dielektrikumsschicht 65 und darauf die Top-Elektrode 66. Das Dielektrikum 65 ist Tantalpentoxid auf der Oberfläche des Wolframs der ersten (Bottom-)Elektrode.

## Patentansprüche

1. Verfahren zur Herstellung eines miniaturisierten Kondensators mit einer ersten Elektrode (4) mit vorgegebener makroskopischer Form (132, 132', 132"), einem darauf aufgebrachten Dielektrikum (5) und einer darauf befindlichen zweiten Elektrode (6), umfassend die folgenden Schritte:
a) in einer Aussparung (32) einer Oxidschicht (31) wird ein zumindest in seinem oberflächennahen Bereich aus Wolframsilizid (WSiₓ, x = 2 bis 2,5) bestehender Körper (132, 132',132") für die erste Elektrode (4) hergestellt,
b) nach Entfernen der Oxidschicht (31) durch Ätzen wird der Körper (132, 132', 132") mit einer Schicht (33) aus unterstöchiometrischem Wolframsilizid WSiₓ, mit x zwischen 1,5 und 1,9, beschichtet,
c) darauf wird eine weitere Schicht (34) aus zusatzfreiem Silizium aufgebracht,
d) dieser Aufbau mit diesen beiden Schichten (33, 34) wird dann in einer inerten Atmosphäre getempert, bis sich eine die erste Elektrode (4) darstellende gekörnte Schicht (41) aus im Wesentlichen der unterstöchiometrischen Wolframsilizidschicht (33) gebildet. hat, und
e) auf die gekörnte Schicht (41) werden nacheinander das Dielektrikum (5) und die zweite Elektrode (6) abgeschieden.

2. Verfahren nach Anspruch 1,
**dadurch gekennzeichnet, dass**
der Körper (132) durchgängig aus dem Wolframsilizid (WSiₓ, x = 2 bis 2,5) hergestellt wird.

3. Verfahren nach Anspruch 1,
**dadurch gekennzeichnet, dass**
der Körper (132') aus Polysilizium hergestellt und mit Wolframsilizid (WSiₓ, x = 2 bis 2,5) als oberflächennahem Bereich beschichtet wird.

4. Verfahren nach einem der Ansprüche 1 bis 3,
**dadurch gekennzeichnet, dass**
die unterstöchiometrische Wolframsilizid-Schicht (33) mit einer Dicke zwischen 10 und 30 nm aufgebracht wird.

5. Verfahren nach einem der Ansprüche 1 bis 4,
**dadurch gekennzeichnet, dass**
die unterstöchiometrische Wolframsilizid-Schicht (33) derart aufgebracht wird, dass diese Schicht (33) auf dem Körper (132, 132', 132") wenigstens zweimal dicker als auf an den Körper (132, 132', 132") angrenzenden Flächen (133) aufgebracht wird.

6. Verfahren nach einem der Ansprüche 1 bis 5,
**dadurch gekennzeichnet, dass**
die Siliziumschicht (34) mit einer Dicke zwischen 10 und 30 nm aufgebracht wird.

7. Verfahren nach einem der Ansprüche 1 bis 6,
**dadurch gekennzeichnet, dass**
das Tempern in inerter Atmosphäre bei 800° bis 1100°C 1 bis 10 s lang andauernd ausgeführt wird.

8. Verfahren nach einem der Ansprüche 1 bis 7,
**dadurch gekennzeichnet, dass**
auf der gekörnten Schicht (41) nach dem Tempern verbliebene Anteile der Siliziumschicht (34) entfernt werden.

9. Verfahren nach einem der Ansprüche 1 bis 8,
**dadurch gekennzeichnet, dass**
die Oberfläche der gekörnten Schicht (41) passiviert wird.

10. Verfahren nach Anspruch 9,
**dadurch gekennzeichnet, dass**
die Passivierung durch thermische Nitrid-Beschichtung erfolgt.

11. Verfahren nach Anspruch 10,
**dadurch gekennzeichnet, dass**
die Passivierung mit einer Monolage-Dicke unterhalb 1 nm ausgeführt wird.

## Claims

1. Method for fabricating a miniaturized capacitor having a first electrode (4) of predetermined macroscopic form (132, 132', 132"), a dielectric (5) applied to the first electrode, and a second electrode (6) located on the dielectric, comprising the following steps:
a) a body (132, 132', 132"), which at least in its region close to the surface consists of tungsten silicide (WSiₓ, x = 2 to 2.5), for the first electrode (4) is fabricated in a recess (32) in an oxide layer (31),
b) after removal of the oxide layer (31) by etching, the body (132, 132', 132") is coated with a layer (33) of substoichiometric tungsten silicide WSiₓ, with x being between 1.5 and 1.9,
c) a further layer (34) of additive-free silicon is applied thereto,
d) this structure having these two layers (33, 34) then undergoes a heat treatment in an inert atmosphere, until a grained layer (41) substantially comprising the substoichiometric tungsten silicide layer (33), which constitutes the first electrode (4), has formed, and
e) the dielectric (5) and the second electrode (6) are deposited in succession on the grained layer (41).

2. Method according to Claim 1, **characterized in that** the body (132) is fabricated all the way through from the tungsten silicide (WSiₓ, x = 2 to 2.5).

3. Method according to Claim 1, **characterized in that** the body (132') is fabricated from polysilicon and is coated with tungsten silicide (WSiₓ, x = 2 to 2.5) as the region close to the surface.

4. Method according to one of Claims 1 to 3, **characterized in that** the substoichiometric tungsten silicide layer (33) is applied in a thickness of between 10 and 30 nm.

5. Method according to one of Claims 1 to 4, **characterized in that** the substoichiometric tungsten silicide layer (33) is applied in such a manner that, on the body (132, 132', 132"), this layer (33) is applied in a thickness which is at least twice that on the surfaces (133) adjoining the body (132, 132', 132").

6. Method according to one of Claims 1 to 5, **characterized in that** the silicon layer (34) is applied in a thickness of between 10 and 30 nm.

7. Method according to one of Claims 1 to 6, **characterized in that** the heat treatment is carried out in an inert atmosphere at 800° to 1100°C for 1 to 10 s.

8. Method according to one of Claims 1 to 7, **characterized in that** parts of the silicon layer (34) which remain on the grained layer (41) after the heat treatment are removed.

9. Method according to one of Claims 1 to 8, **characterized in that** the surface of the grained layer (41) is passivated.

10. Method according to Claim 9, **characterized in that** the passivation takes place by thermal nitride coating.

11. Method according to Claim 10, **characterized in that** the passivation is carried out with a monolayer thickness of less than 1 nm.

## Revendications

1. Procédé de fabrication d'un condensateur miniaturisé ayant une première électrode (4) d'une forme (132, 132', 132") macroscopique prescrite, un diélectrique (5) déposé dessus et une deuxième électrode (6) se trouvant dessus, comprenant les stades suivants :
a) on produit pour la première électrode (4) dans un évidement (32) d'une couche (31) d'oxyde un corps (132, 132', 132") constitué au moins dans sa partie proche de la surface de siliciure de tungstène (WSiₓ, x = 2 à 2, 5) ,
b) après avoir éliminé la couche (31) d'oxyde par attaque, on revêt le corps (132, 132', 132") d'une couche (33) en siliciure de tungstène hypostoechiométrique WSiₓ, avec x compris entre 1,5 et 1,9,
c) on dépose dessus une autre couche (34) en silicium exempt d'additif,
d) on traite ensuite thermiquement cette structure ayant ces deux couches (33, 34) dans une atmosphère inerte jusqu'à ce qu'il se forme une couche (41) granulée représentant la première électrode (4) sensiblement à partir de la couche (33) de siliciure de tungstène hypostoechiométrique et
e) on dépose sur la couche (41) granulée l'un après l'autre le diélectrique (5) et la deuxième électrode (6).

2. Procédé suivant la revendication 1,
**caractérisé en ce que**
l'on produit le corps (132) dans son entier en le siliciure de tungstène (WSiₓ, x = 2 à 2,5).

3. Procédé suivant la revendication 2,
**caractérisé en ce que**
l'on produit le corps (132') en polysilicium et on le revêt de siliciure de tungstène (WSiₓ, x = 2 à 2,5) en tant que partie proche de la surface.
l'on produit le corps (132') en polysilicium et on le revêt de siliciure de tungstène (WSiₓ, x = 2 à 2,5) en tant que partie proche de la surface.

4. Procédé suivant l'une des revendications 1 à 3,
**caractérisé en ce que**
l'on dépose la couche (33) de siliciure de tungstène hypostoechiométrique en une épaisseur comprise entre 10 et 30 nm.

5. Procédé suivant l'une des revendications 1 à 4,
**caractérisé en ce que**
l'on dépose la couche (33) de siliciure de tungstène hypostoechiométrique de façon à ce que cette couche (33) soit déposée sur le corps (132, 132', 132") en une épaisseur au moins deux fois plus grande que sur les surfaces (133) voisines du corps (132, 132', 132").

6. Procédé suivant l'une des revendications 1 à 5,
**caractérisé en ce que**
l'on dépose la couche (34) de silicium en une épaisseur comprise entre 10 et 30 nm.

7. Procédé suivant l'une des revendications 1 à 6,
**caractérisé en ce que**
l'on effectue le traitement thermique en atmosphère inerte entre 800°C et 1100°C pendant une durée de 1 à 10 secondes.

8. Procédé suivant l'une des revendications 1 à 7,
**caractérisé en ce que**
l'on élimine sur la couche (41) granulée des parties de la couche (34) de silicium qui subsistent après le traitement thermique.

9. Procédé suivant l'une des revendications 1 à 8,
**caractérisé en ce que**
l'on passive la surface de la couche (41) granulée.

10. Procédé suivant la revendication 9,
**caractérisé en ce que**
l'on effectue la passivation par un revêtement thermique de nitrure.

11. Procédé suivant la revendication 10,
**caractérisé en ce que**
l'on effectue la passivation par une épaisseur de monocouche inférieure à 1 nm.
